# EUROPEAN PATENT APPLICATION

(11) **EP 4 678 392 A1**
(43) Date of publication of application: **14.01.2026**
(21) Application number: 24187319.9
(22) Date of filing: 09.07.2024
(51) Int. Cl.: B32B 7/12, B32B 3/08, B32B 3/26, B32B 15/10, B32B 21/08, B32B 21/14, H05K 3/00

(54) **LAYERED PRODUCT AND METHOD FOR MANUFACTURING THEREOF**

(71) Applicant: Koskisen Oyj, 16600 Järvelä (FI)
(72) Inventor: TARULA, Mikko, 16600 Järvelä (FI)
(74) Representative: Laine IP Oy

(57) **Abstract**

According to an example aspect of the present invention, there is provided a layered product comprising a body layer (1), a cover layer (2) and a layer of printed electronics (3) set between the body layer (1) and the cover layer (2). Adhesive is used for bonding the layers (1, 2, 3) together. In the layer of printed electronics (3) are openings (5) through which the adhesive makes contact to the body layer (1) and the cover layer (2).

## Description

### FIELD

The invention relates to layered products wherein one of the layers comprises a layer of printed electronics. Specifically, the invention relates to integration of a functional layer to a panel structure. More specifically, the invention relates to plywood boards having a layer of printed electronics within the ply layers.

### BACKGROUND

Modern manufacturing methods for electronics and electric circuits make it possible to implement electric and electronic elements in large variation of applications. One such application is to embed electronics within layered structures, for example inside a plywood board. The electronics may include batteries, lights, electric and data contacts, sensors and detectors as well as transmission apparatus for receiving and sending data.

EP 376 09 87 discloses an apparatus and a method for monitoring weight of a load stored on at least one plate. The weight sensors and other electronics are placed on a board that includes a flexible layer wherein the sensors are embedded. Further applications wherein weight sensors are used in combination with floor panels of a vehicle are disclosed in WO 2017/163 105, US 2017 307 433, EP 2 821 761 and EP 2 2 61 613.

### SUMMARY OF THE INVENTION

The invention is defined by the features of the independent claims. Some specific embodiments are defined in the dependent claims.

According to a first aspect of the present invention, there is provided a layered product comprising a body layer, a cover layer and a layer of printed electronics set between the body layer and the cover layer and adhesive bonding the layers together. The layer of printed electronics has openings through which the adhesive makes contact to the body layer and the cover layer.

According to a second aspect of the present invention, there is provided method for producing a layered product comprising providing a body layer, a cover layer and a layer of printed electronics, wherein adhesive is spread at least on one of the layers and the layers are placed in contact with each other so that the layer of printed electronics having openings is set between the body layer and the cover layer and adhesive is spread so that the adhesive makes contact to the body layer and the cover layer through the openings in the layer of printed electronics.

According to further aspects of the present invention, there is provided following features that may be combined with the invention according to the first or second aspect:
a) the layer of printed electronics is a pre-printed sheet;
b) the layer of printed electronics is printed on the body layer or the cover layer or both;
c) one of the body layers and the cover layer comprises wood:
d) the body layer and the cover layer are wood, especially plywood or a veneer ply;
e) the layer of printed electronics comprises one or more components from a group: wirings, sensors, resistors, antennae, LED's, heating elements, switches, batteries, power harvesting or controllers.
f) the layered product comprises two layers of printed electronics and a divider layer between the layers of printed electronics;
g) the cover layer is single veneer ply;
h) the layer of printed electronics is printed by using 3D printing method;
i) the cover layer has access openings for access for the electronics elements through the cover layer,
j) the layered product comprises fastening elements passing through the openings for attaching layers of the product together,
k) the layered product comprises fastening elements passing through the openings for attaching the product toa support structure,

1) the layered product comprises holes passing through the openings.

### BRIEF DESCRIPTION OF THE DRAWINGS

FIGURE 1 illustrates schematically a layered product in accordance with at least some embodiments of the present invention;
FIGURE 2 illustrates schematically an example apparatus capable of supporting at least some embodiments of the present invention.

### EMBODIMENTS

### DEFINITIONS

In the present context, the term "layer of printed electronics" comprises pre-printed sheets and foils comprising embedded printed electronics components or a layer printed directly on a support substance.

A veneer ply is a thin ply of wood material.

The invention is related to embedding electronic functionalities on a layered product, especially products based on wood materials such as plywood. The embedding is made using printed electronics. The problem related to including a layer of printed electronics between layers of other materials is that the layer of printed electronics and the materials used as supporting or covering layers may not be joinable with same adhesives or bond to one of the materials, usually the printed layer, is weak and doesn't provide sufficient structural strength. The layer may separate at the printed layer and the product is thereafter waste. Now, when a layer of printed electronics has openings, the adhesive forms bond through the openings. This provides structurally strong product that can be used even purposes where stresses are high, for example on floors of trucks and lorries.

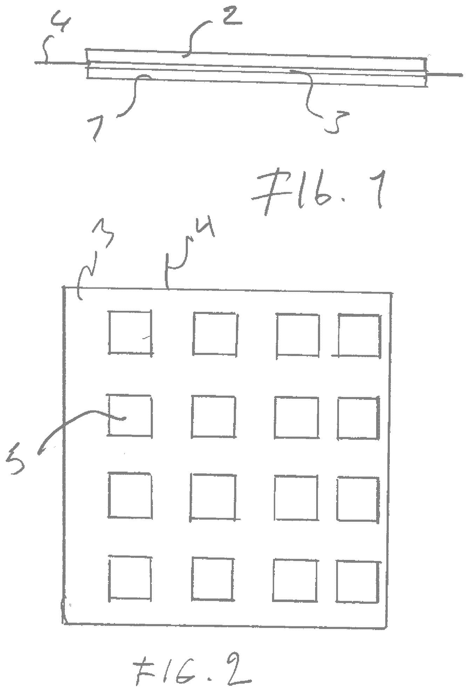

FIGURE 1 illustrates in a side view a layered product in accordance with at least some embodiments of the present invention. A body layer 1 forms a support on which a layer of printed electronics 3 is placed. On the layer of printed electronics 3 is a cover layer 2. Connectors 4 are depicted schematically. The connectors 4 may include electric, optical or other contact to the electronics in the layer of printed electronics 3.

The body layer 1 and the cover layer 2 may take various forms. Usually, but not exclusively, the body layer 1 forms the load carrying part of the layered product. The body layer 1 can be made of a material providing a good structural strength. Such materials include plywood, chipboard, fibre board, MDF, HDF, plastic, plastic and fibre composites, honeycombs, for example. The choice of material of the body layer is decided on where the layered product is used, for example how much structural strength is needed and what are the environmental demands. The cover layer 2 may be chosen from same group of materials. If body layer is used as primary load bearing the structure, the cover layer may be thin material, for example a single veneer ply. The veneer ply may be even partially transparent. If transparency like opaque or translucent cover layer is needed, that can be accomplished by a thin veneer ply. For total transparency a plastic foil or sheet is needed. The cover layer can be made of two or more materials placed on top of each other or different materials may be varied over the surface of the layered product to obtain desired functional sections and decorative appearance. The cover layer can be a rubber sheet, aluminium or copper sheet or foil or other suitable coating sheet or plate. Even use of a fabric can be contemplated. Choosing different kind of cover layer, the appearance and properties of the layered product can be adjusted for several purposes.

The functionalities of the layered product are accomplished by the layer of printed electronics 3. This layer can be made as a pre-printed sheet that includes desired electronics components. One example of such a foil has a PET-substrate on which the electronics is printed. The layer of printed electronics can be printed directly on the body layer or the cover layer. For example, electronic components and circuitry can be printed directly on wood surfaces and many other materials. 3D-printing provides also a lucrative possibility for making the layer of printed electronics. Whatever the chosen printing method is, the printed layer has to have at least one opening going through the layer of printed electronics to allow joining the body layer and the cover layer by adhesive through the opening. The openings provide a further benefit of providing free areas for placing fastening elements such as rivets, bolts or screws through the layered product. The fastening elements can be used for securing the cover layer and the body layer to each other and for attaching the layered product to supporting structure. One or both of he surfaces of the layered product may include markings for placement of the fastening elements or other fittings attached to the layered product at the openings. Also, if there is need to make a hole through the layered product, that can be done at the openings 5.

The adhesive used for joining the body layer to the cover layer can be chosen quite freely. Of course, the materials to be joined set requirements that limit the choice. One factor that may be considered is elasticity of the adhesive and thickness of the adhesive layer. By varying the elasticity of the adhesive, the compressibility of the adhesive seam can be adjusted to the sensors and other electronics components placed in the layer of printed electronics. For example, pressure sensors may need certain compressibility to operate reliably. Further, if the thickness of the layer of printed electronics varies, a thicker adhesive layer can be used to accommodate bulkier electronic components.

One example of suitable adhesives is a two component isocyanate-based glues. One commercially available alternative is SikaForce^{®}--420L45. One elastic alternative is elastic dispersion polymer based coating and bonding materials. A commercially available alternative is Elaproof elastomer. As the bonding is based on bonding action through the openings in the layer of printed electronics, the adhesive used is chosen to give good bonding between the materials of the body layer and he cover layer, taking int account the elasticity needed.

The layered product may comprise two or more layers of printed electronics separated by a divider layer. Such product is feasible when, for example, two preprinted electronics sheet having different components are needed. One of the preprinted sheets may include sensors and elements related to their operation and the other layer may comprise data transmission and handling equipment. Or one of the preprinted sheets may include pressure sensors and the other heating elements. Such an layered product could be used for a floor of a cargo vehicle providing load sensors and defrosting of the floor.

The layered product described above can be manufactured by using machinery used in plywood industry. The adhesive is spread preferably by using robots as strips, spray or by a roll. However, any machinery capable of handling large plates is usable. If products having smaller dimensions are manufactured, the number of manufacturing methods increases.

The invention can be utilized for making a large variety of products. Some examples are given below.

A load sensing floor structure for cargo vehicles can be produced by using a preprinted pressure sensor sheet that is placed between two plywood layers as described above. Such a floor would enable detecting location and weight of loaded cargo in the cargo space. The information can be transferred to a separate display or a display of the vehicle by connectors 4 or wirelessly if wireless data transfer is provided. The wireless communication can be provided in the structure of the floor in a layer of printed electronics or as a separate unit. The information can also be transferred to the cloud-based software, mobile application or to fleet management software's. The information can also be provided directly to the software of the vehicle itself.

A heating element for floors, walls or ceilings can be provided by embedding heating elements in the layered product as layer of printed electronics. Similarly, a lighting panel can be provided by a layer of printed electronics. The cover layer may in this case be translucent or transparent. By varying the type, colour and transparency, a large variety of lighting panels can be provided. Of course, the choice of LED,s give further alternatives.

The invention provides many alternative products. However, the main focus of the invention is layered products made of wood based of wood materials as body layer and cover layer. Reason for this is that bonding two wood based/wood materials together by adhesives gives good bond and strong structure using adhesives known to function well in this use.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various embodiments and example of the present invention may be referred to herein along with alternatives for the various components thereof. It is understood that such embodiments, examples, and alternatives are not to be construed as de facto equivalents of one another, but are to be considered as separate and autonomous representations of the present invention.

Furthermore, the described features, structures, or characteristics may be combined in any suitable manner in one or more embodiments. In the following description, numerous specific details are provided, such as examples of lengths, widths, shapes, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

While the forgoing examples are illustrative of the principles of the present invention in one or more particular applications, it will be apparent to those of ordinary skill in the art that numerous modifications in form, usage and details of implementation can be made without the exercise of inventive faculty, and without departing from the principles and concepts of the invention. Accordingly, it is not intended that the invention be limited, except as by the claims set forth below.

The verbs "to comprise" and "to include" are used in this document as open limitations that neither exclude nor require the existence of also un-recited features. The features recited in depending claims are mutually freely combinable unless otherwise explicitly stated. Furthermore, it is to be understood that the use of "a" or "an", i.e. a singular form, throughout this document does not exclude a plurality.

### INDUSTRIAL APPLICABILITY

The invention can be utilized for manufacturing layered products such as composite boards having various embedded functionalities.

### ACRONYMS LIST

- MDF: Medium density fiber board
- HDF: High density fiber board

### REFERENCE SIGNS LIST

- 1: body layer
- 2: cover layer
- 3: layer of printed electronics
- 4: connector
- 5: opening

### CITATION LIST

### Patent Literature

EP 376 09 87, WO 2017/163 105, US 2017 307 433, EP 2 821 761, EP 2 2 61 613

## Claims

1. A layered product comprising:
- a body layer (1);
- a cover layer (2), and
- a layer of printed electronics (3) set between the body layer (1) and the cover layer (2), and
- adhesive bonding the layers (1, 2, 3) together,
**characterized in that** the layer of printed electronics (3) has openings (5) through which the adhesive makes contact to the body layer (1) and the cover layer (2).

2. A layered product according to the claim 1, wherein the layer of printed electronics (3) is a pre-printed sheet.

3. A layered product according to the claim 1, wherein the layer of printed electronics (3) electronics is printed on the body layer (1) or the cover layer (2) or both;

4. A layered product according to one of the claims 1 - 3, wherein the body layer (1) and the cover layer (2) are wood or wood-based material, especially plywood or a veneer ply.

5. A layered product according to any of the preceding claims, wherein the layer of printed electronics (3) comprises one or more components from a group: wirings, sensors, resistors, antennae, leds, heating elements, switches, batteries, power harvesting or controllers.

6. A layered product according to one of the preceding claims, wherein the layered product comprises two layers of printed electronics (3) and a divider layer between the layers of printed electronics (3).

7. A layered product according one of the preceding claims, wherein the cover layer (2) is single veneer ply.

8. A Layered product according one of the claims 1, 4-7, wherein the layer of printed electronics (3) is printed by using 3D printing method.

9. A layered product according to one of the preceding claims, wherein the cover layer (2) has access openings for access for the electronics elements through the cover layer (2).

10. A layered product according to one of the preceding claims comprising fastening elements passing through the openings (5) for attaching layers of the product together.

11. A layered product according to one of the preceding claims comprising fastening elements passing through the openings (5) for attaching the product toa support structure,

12. A layered product according to one of the preceding claims, comprising holes passing through the openings (5).

13. A method for producing a layered product comprising:
- providing a body layer (1), a cover layer (2) and a layer of printed electronics (3) having openings (5),
- spreading adhesive at least on one of the layers, and
- placing the layers in contact with each other so that the layer of printed electronics (3) having openings (5) is set between the body layer (1) and the cover layer (2) and adhesive is spread so that the adhesive makes contact to the body layer (1) and the cover layer (2) through the openings (5) in the layer of printed electronics (3).
